# EUROPEAN PATENT APPLICATION

(11) **EP 0 714 999 A1**
(43) Date of publication of application: **05.06.1996**
(21) Application number: 95420314.7
(22) Date of filing: 15.11.1995
(51) Int. Cl.: C23C 16/44, C23C 16/26, B01D 7/00

(54) **Method for sublimating a solid material and a device for implementing the method**

(30) Priority: 30.11.1994 FR 9414613
(71) Applicant: KODAK-PATHE, F-75594 Paris Cedex 12 (FR); EASTMAN KODAK COMPANY, Rochester, New York 14650-2201 (US)
(72) Inventor: Garenne, Jean-Jacques Edgar, Kodak-Pathé, F-71102 Chalon sur Saone Cedex (FR); Poncelet, Olivier Jean Christian, Kodak-Pathé, F-71102 Chalon sur Saone Cedex (FR)
(74) Representative: Boulard, Denis

(57) **Abstract**

The invention concerns a method and a device for sublimating a solid material.

The device according to the invention comprises: a) an enclosure (10) into which the solid material is introduced, which is held between two plates (13) of porous material; b) means (14) for sublimating the solid material inside the enclosure (10) so as to produce a vapour phase from the solid material; c) means (11, 12) for introducing into the enclosure (10) a carrier gas for conveying the vapour phase; and d) means (15, 17) for evacuating the vapour phase and the carrier gas.

Application to the sublimation of amino-borane powder for the doping of diamond layers.

## Description

### FIELD OF THE INVENTION :

The invention concerns a method and a device for sublimating a solid material. The invention can be applied in any apparatus for vacuum or vapour phase chemical deposition (CVD - chemical vapour deposition).

### BACKGROUND OF THE INVENTION :

There are numerous CVD deposition techniques. For example, the so-called "plasma enhanced CVD" technique (PECVD) can be cited, according to which a reactor is used formed principally by a chamber able to be closed hermetically and inside which a negative pressure can be applied by means of pumps. The component or components that are to be coated are put on a metal support (the substrate-carrier cathode) connected to a current generator, if necessary through a sealed insulator. The gases (for example, in cases where layers of pseudo-carbon diamond are to be deposited, carbon-containing gases are used which contain notably one or more hydrocarbons, most often methane, acetylene, propane or butane, to which hydrogen or inert gases, notably argon, are optionally added) can be introduced into the reactor through metering valves while the pumps are in operation. Under required pressure and electrical power conditions, the gas is excited physically and chemically and ionised so that the atoms partly lose their electrons as they are transformed into positive particles, thereby forming a plasma which causes a "cracking" of the gaseous mixture, which is deposited on the component to be coated. The volume of plasma is surrounded by a so-called "sheath" zone through which the ions are accelerated (plasma physics). Typically, the generator generally consists of a highfrequency generator working in a frequency range of 2 to 20 MHz so as to supply the energy required to maintain an electrical discharge. Deposition by this technique has been the subject of publications (see, for example, Klages, Appl. Phys. A56 (1993) 513-526).

Another CVD deposition technique consists of a so-called hot filament CVD deposition (HFCVD) (see, for example, Klages, Appl. Phys. A56 (1993) 513-526). Thus, for example, in the field of deposition of diamond layers, an item of equipment is used that typically comprises a water-cooled stainless steel vacuum chamber which is evacuated by means of a two-stage pump. The component to be coated is placed on a substrate carrier, in the vicinity of which is disposed a filament brought to a temperature of approximately 2000°C, the function of which is to break the gas molecules into elements which will then be able to be deposited. In the preparation phase for the deposition to be carried out, a pressure lower than 10⁻² mbar is applied inside the chamber. The deposition of the film is carried out by the admission into the chamber of hydrogen and methane producing an operating pressure of approximately 60 mbar.

According to another technique known as the "electron assisted CVD technique" (EACVD), the top part of a substrate is maintained at a temperature of at least 400°C in an atmosphere of a gaseous mixture (for diamond deposition, hydrogen and a hydrocarbon are used) under reduced pressure conditions. The top surface is subjected to a bombardment of electrons, which are then removed from said surface, bringing about the formation of diamond crystal nuclei. The nuclei formed in this way will grow, so as to form a thin layer of diamond. Such a technique is described in detail in US patent 4 740 263.

The field of application of the present invention also embraces all the well known types of vacuum deposition equipment. This equipment has been the subject of numerous publications in the patent literature and consequently does not require any special elaboration.

Within the framework of certain applications, it is necessary to dope the deposited material with various elements. For example, it can be necessary with certain applications to dope films of diamond so as to make them conductive in order to produce electrodes from them. In this application, boron is used to dope the deposit produced. Such films of diamond doped with boron are described, for example, in the patent EP-A-509 875. According to the technique described in this document, boron precursors are introduced into the reactor in gaseous form. For example, a gaseous mixture of borane diluted in hydrogen is used. The problem with such an approach lies principally in the fact that BH₃ dimerizes rapidly into B₂H₆, which polymerises in the form of stable polyborane. The formation of these polyboranes may compete directly with the doping of the diamond deposition. Furthermore, borane is toxic in its gaseous form, which entails costly safety equipment for its handling.

According to another approach, it has been proposed to use the doping agent in solid form, disposed in a crucible, which is introduced into the deposition chamber. This technique presents problems related to the decomposition of the solid product and to the fact that it is very difficult to control with precision the reaction and the doping conditions produced. Moreover, solid precursors are often highly reactive to atmospheric moisture and their solid nature increases the difficulty of volatilizing them evenly. One of the best examples illustrating this phenomenon is Ba(thd)₂, which is the molecular precursor used for the organic metal CVD deposition of perovskite-type materials (such as YBa₂Cu₃O₇₋ₓ, and/or BaTiO₃). It has been demonstrated recently that Ba(thd)₂ species are highly sensitive to contamination by very small quantities of water, which brings about the polymerisation of the compounds, reducing their volatility and giving rise to their thermal degradation. This problem leads to these precursors being used in drastic conditions, of the type with handling at -70° with a heat treatment limited to 2 hrs. This increases considerably the cost and complexity of the method and of the equipment; similarly, the deposition process is not very reproducible (because of the contamination of the deposition by certain reaction by-products and, overall, poor control of the stoichiometric conditions). These difficulties are due principally to the design of the devices used for the sublimation of solid precursors.

One of the objects of the present invention is therefore to provide a sublimation device and method allowing, for example, the doping of deposits produced by vacuum deposition or CVD deposition techniques using a material in solid form which does not have the drawbacks discussed above with reference to the conventional techniques.

For example, one of the objects of the invention is to provide a sublimation device which optimizes the mixture of reactive vapours with the carrier gases.

Another object of the invention is to provide a sublimation device which substantially improves handling conditions, notably when highly reactive molecules are loaded.

Other objects of the present invention will appear in detail in the following description.

### SUMMARY OF THE INVENTION :

These objects, and others, are achieved according to the invention by means of a device for the sublimation of a solid material, the device comprising:
a) an enclosure into which the solid material is introduced;
b) means for sublimating the solid material inside the enclosure in order to produce a vapour phase from the solid material;
c) means for introducing into the enclosure a carrier gas for conveying the vapour phase; and
d) means for evacuating the vapour phase and the carrier gas;
the device being characterised in that it comprises, inside the enclosure, two plates of a porous material between which the solid material is held.

For example, the solid material is an amino-borane compound in powder form.

According to a first embodiment, the means for sublimating the solid material consist of means for heating said enclosure.

Advantageously, it additionally comprises means enabling the porous plates to be heated directly.

According to another embodiment, the device further comprises means for cooling the enclosure so as to keep materials solid which, under normal temperature conditions, would be in the liquid state.

Also advantageously, means are used, according to the invention, which enable a negative pressure suitable for lowering the vaporisation temperature of the solid material to be applied inside the enclosure.

Preferably, the porous plates are formed from a sintered metal or glass.

According to one advantageous alternative, the solid material is loaded into the enclosure in an inert gas, such as argon.

According to a second alternative, the solid material is loaded into the enclosure under vacuum.

The invention also concerns a method for the sublimation of a solid material consisting of introducing the solid material into an enclosure inside which the conditions are adjusted so as to allow the sublimation of the solid material in order to produce a vapour phase from it and to put the solid material in contact with a carrier gas so as to provide conveyance out of the enclosure of the vapour phase thereby produced, the method being characterised in that the solid material is put in contact with said vector gas by means of two plates of a porous material between which the solid material is disposed.

The invention also concerns CVD deposition equipment in which at least one compound in the vapour phase is deposited on a support, characterised in that it uses a sublimation device according to the invention.

According to a first example, the deposition is effected using the plasma enhanced CVD technique (PECVD).

According to a second example, the deposition is effected using the hot filament CVD technique (HFCVD).

According to a third example, the deposition is effected using the electron-assisted CVD technique (EACVD).

### BRIEF DESCRIPTION OF THE DRAWINGS :

In the following description, reference will be made to the drawings in which:
- Fig 1 depicts diagrammatically HFCVD equipment able to use the sublimation device according to the present invention; and
- Fig 2 depicts diagrammatically an example embodiment of the sublimation device according to the invention.

### DETAILED DESCRIPTION OF THE INVENTION :

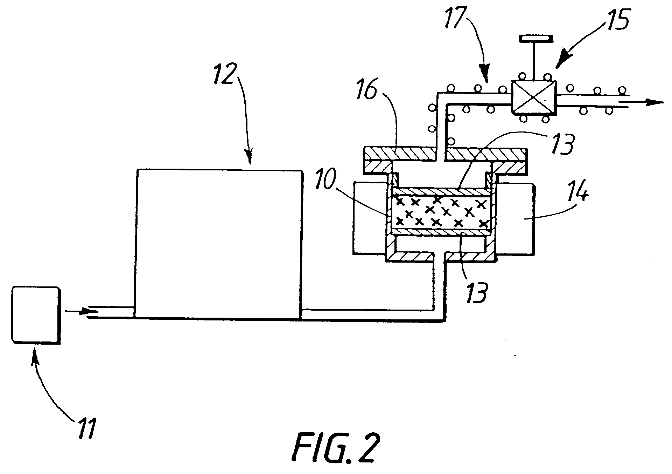

Fig 2, to which reference is now made, illustrates diagrammatically a CVD deposition device using the hot filament CVD technique. In the example depicted, the device is used to produce diamond electrodes. It is obvious that other applications can be envisaged.

Typically, such equipment comprises a vacuum chamber made of stainless steel 1. Means (not shown) are provided for cooling the chamber 1, which vacuum chamber is evacuated by means of a two-stage pump 2. The component to be coated 3 is laid on a substrate carrier 4 in the vicinity of which a filament 5 is disposed which is brought to a temperature of approximately 2000°C and whose function is to break the gas molecules into elements that will then be able to be deposited. By way of example, a tungsten, tantalum or rhenium filament, fixed between two copper electrodes, is used. The intensity of the current is kept constant through the use of a power supply stabilizer. Generally, the distance between the filament and the substrate is greater than 10 mm. In the case of a deposition of diamond layers, a gaseous mixture of H₂ and CH₄ is used. The filament and the substrate are first heated to temperatures below the deposition temperature in a hydrogen atmosphere (with a pressure of approximately 60 mbar). Methane is then introduced into the reaction chamber.

When, for certain applications, it is necessary to dope the deposition produced, a gas which, according to the present invention, is obtained by sublimation of a solid material such as a powder is introduced into the reaction chamber 1. For this purpose, and according to the present invention, a sublimater 6, which will be described in greater detail below, is used.

Fig 2 depicts diagrammatically an embodiment of the sublimater according to the invention. This principally comprises an enclosure 10 connected to a source of carrier and/or reactive gas 11 through a flowmeter 12. The enclosure contains the solid material from which the doping gas is to be obtained. Advantageously, the material is in the form of a powder which, according to the invention, is held in the enclosure between two plates 13 of a porous material. The material forming the porous plates is chosen so as to be preferably heatable, and inert in relation to the product to be sublimated. The plates are held in place in the enclosure by means of shoulders or other equivalent mechanical means. According to a particular example, the enclosure is produced from stainless steel. Its volume is approximately 20 cm³. Numerous porous materials can be used according to the invention. By way of example, sintered materials such as glass or any metal able to be sintered (stainless steel, nickel, etc) may be cited. According to another example, porous alumina or a porous organic material such as polyethylene, polypropylene or another equivalent material is used. In reality, the choice of porous material is made according to the heat treatment that will be applied to it and the nature of the solid to be sublimated. These plates can also take the form of a sieve, such as a sieve made from stainless steel or other appropriate material. Preferably, the porous material is chosen so that the size of the pores is less than or equal to the size of the constituents of the solid material or of the powder particles. A mutual coalescence of the particles is to be noted during the sublimation process so that the average size of the powder particles remains substantially identical during the sublimation process.

The sublimation of the solid material inside the enclosure 10 is produced either by heating (see heating means 14), or by applying an appropriate negative pressure inside the enclosure so as to lower the vaporisation temperature of the material, or by a combination of the above two techniques. According to one embodiment, the vacuum in the enclosure 10 is provided by the negative pressure existing in the reactor 1 (pump 2). Advantageously, at least one of the porous plates is heated directly, by Joule effect, for example, or by a heat-exchange fluid. The material forming the plates must, therefore, be chosen so as to be conductive. Graphites or conductive carbons will, for example, be used. The advantage of this solution lies in the fact that the problems of condensation are partly eliminated. A better homogeneity of heating is, moreover, obtained.

A carrier gas is introduced into the enclosure so as to convey the vapour phase of the sublimated solid material. According to one preferred embodiment, a gas is used which, as well as the conveying, reacts with the solid material.

According to another embodiment, the enclosure is cooled to temperatures that can reach -70°C. This enables products which, under normal temperature conditions, would be in the liquid state, a state in which they would be difficult or dangerous to handle, to be made solid. It is also possible to control effectively the change into the vapour phase by adjusting the temperature. By way of example, the enclosure 10 is connected to a cryostat or to a Peltier effect system.

Similarly, for products sensitive to contamination by air, and in particular by the moisture present in the ambient atmosphere, it is possible to provide for the charging of the enclosure 10 with solid material under inert gas or under vacuum. In this case, one valve 15 is provided downstream of the enclosure 10 and one (not shown) upstream of the enclosure to allow such a charging. By way of example, the enclosure is charged under argon or nitrogen. For charging under vacuum, the Schlenk technique or the glove box technique is, for example, used.

The enclosure has a removable lid 16 through which an opening connected by a pipe 17 to the CVD deposition reactor is formed. In order to avoid problems of condensation, the pipe 17 and the valve 15 are thermostatically controlled by means, for example, of a heating filament wound on the pipe 17, and on the valve 15.

### Example

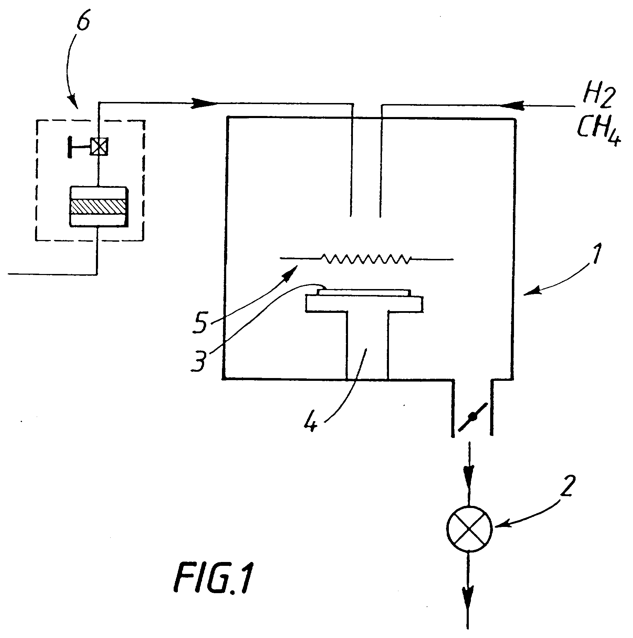

The sublimater according to the invention is used in a process for the manufacture of diamond electrodes using an HFCVD deposition technique as illustrated in Fig 1. The solid material consists of a powder of boron precursors of the amino-borane type of the general formula RR'R"N.BH₃ in which R, R' and R" can be either hydrogen, or an alkyl group, substituted or otherwise, or an aromatic group with 5 or 6 members, substituted or otherwise. These amino-boranes are chosen from amongst the following compounds: (CH₃)₃N.BH₃, (C₂H₅)₃N.BH₃, (CH₃)₂NH.BH₃, [(CH₃)₂CH]₂NC₂H₅.BH₃, (CH₃)₃CNH₂.BH₃, C₆H₅N(C₂H₅)₂.BH₃ and (C₅H₄)₃N.BH₃.

Plates of sintered stainless steel are used, with a thickness of approximately 1 mm. The thickness of powder between the two plates is approximately 5 mm. As a carrier gas, a gas also reacting with the boron precursor is used. In this example, NH₃ is used.

In the preceding example, the sublimater according to the invention was used in a deposition device using an HFCVD technique. In the same way, such a sublimater could be used in any other CVD deposition device, such as those, for example, discussed in the first part of the description. As mentioned previously, such devices are well known per se and consequently require no additional description. According to another example, the known technique of reactive cathode evaporation vacuum deposition is used.

The sublimation device according to the invention offers a certain number of advantages which are, principally: the control of the flow of carrier gas loaded with active molecules (at the outlet of the sublimater) can be carried out by acting on the temperature of the sublimation enclosure and on the carrier gas flow at the inlet of the sublimater; the gas can act either solely as a carrier, or as a reagent with the solid material to be sublimated so as to increase its reactivity and/or volatility; such a sublimater is easy to load under inert gas such as argon or nitrogen; the porosity and nature of the porous plates can easily be adapted to the reactivity of the products and to the temperature at which they are used; the porosity of the plates allows optimization of the vapour exchanges between the carrier gases and the active powders, thereby enabling the problems of thermal degradation which arise in conventional sublimation devices to be avoided.

Similarly, the invention has been described with reference, principally, to the use of amino-borane powders. It is obvious that such a technique could be used with other chemical compounds in the solid state. By way of example, alkaline-earth and lanthanide dipivaloymethanates can be cited.

The invention has just been described with reference to preferred embodiments. As is self-evident, modifications can be made to it without departing from the spirit of the invention as claimed in the following claims.

## Claims

1. Device for the sublimation of a solid material, said device comprising:
a) an enclosure (10) into which the solid material is introduced;
b) means (14) for sublimating the solid material inside said enclosure (10) in order to produce a vapour phase from said solid material;
c) means (11, 12) for introducing into said enclosure (10) a carrier gas for conveying said vapour phase; and
d) means (15, 17) for evacuating said vapour phase and the carrier gas;
said device being characterised in that it comprises inside the enclosure, two plates (13) of a porous material between which the solid material is held.

2. Device according to Claim 1, characterised in that said solid material is an amino-borane compound in the form of a powder.

3. Device according to Claim 1, characterised in that said means for sublimating the solid material consist of means (14) for heating said enclosure.

4. Device according to Claim 3, characterised in that it additionally comprises means enabling at least one of the porous plates to be heated directly.

5. Device according to Claim 1, characterised in that it additionally comprises means for cooling said enclosure so as to keep in solid form materials which, under normal temperature conditions, would be in the liquid state.

6. Device according to any one of Claims 1 to 5 characterised in that said means for sublimating the solid material consist of means enabling a negative pressure suitable for lowering the vaporisation temperature of the solid material to be applied inside the enclosure (10).

7. Device according to Claim 1, characterised in that the porous plates (13) are formed from a sintered metal or glass.

8. Device according to any one of Claims 1 to 7, characterised in that the solid material is loaded into the enclosure (10) under inert gas.

9. Device according to Claim 8, characterised in that the inert gas is argon.

10. Device according to any one of Claims 1 to 7 characterised in that the solid material is loaded into the enclosure (10) under vacuum.

11. Method for the sublimation of a solid material consisting of introducing the solid material into an enclosure (10) inside which the conditions are adjusted so as to allow the sublimation of said solid material in order to produce a vapour phase from it and to put said solid material in contact with a carrier gas so as to provide conveyance out of said enclosure of the vapour phase thereby produced, said method being characterised in that the solid material is put in contact with said carrier gas by means of two plates (13) of a porous material between which said solid material is disposed.

12. Method according to Claim 11, characterised in that said enclosure is maintained under inert gas when it is loaded with solid material.

13. Method according to Claim 12, characterised in that said inert gas is argon.

14. Method according to Claim 11, characterised in that said enclosure (10) is maintained under vacuum when it is loaded with solid material.

15. Method according to Claim 11, characterised in that said solid material is an amino-borane compound in powder form.

16. Method according to Claim 11 or 12, characterised in that said enclosure (10) is heated.

17. Method according to any one of Claims 11 to 15, characterised in that at least one of the porous plates is heated directly.

18. Method according to any one of Claims 11 to 17, characterised in that a vacuum able to lower the vaporisation temperature of the solid material is applied inside the enclosure (10).

19. Method according to any one of Claims 11 to 16, characterised in that the porous plates (13) are formed from a sintered metal or glass.

20. Device for CVD deposition or vacuum deposition in which at least one compound in the vapour phase is deposited on a support, characterised in that it uses a sublimation device according to any one of Claims 1 to 10.

21. Device according to Claim 20, characterised in that the deposition is effected using the plasma enhanced CVD technique (PECVD).

22. Device according to Claim 21, characterised in that the deposition is effected using the hot filament CVD technique (HFCVD).

23. Device according to Claim 20, characterised in that the deposition is effected using the electron-assisted CVD technique (EACVD).

24. Device according to Claim 20, characterised in that the deposition is effected by reactive cathode evaporation vacuum deposition.
